Europäisches Patentamt

European Patent Office

Office européen des brevets

(11) Publication number: **0 468 067 A1**

# EUROPEAN PATENT APPLICATION

(21) Application number: 90114162.2

(51) Int. Cl.⁵: **D02G 3/32**

(22) Date of filing: **24.07.90**

(43) Date of publication of application:
**29.01.92 Bulletin  92/05**

(84) Designated Contracting States:
**DE ES FR GB IT**

(71) Applicant: **NISSINBO INDUSTRIES, INC.**
**3-10, Yokoyama-cho, Nihonbashi, Chuo-ku**
**Tokyo 103(JP)**

Applicant: **SHIMA SEIKI MFG., Ltd.**
**No. 85, Sakata**
**Wakayama-shi, Wakayama 641(JP)**

(72) Inventor: **Iwata, Kenji c/o Naigai Gosen, Inc.**
**No. 63, Mukai Wakayama-shi**
**Wakayama 640(JP)**
Inventor: **Asano, Katsumi c/o Naigai Gosen,**
**Inc.**
**No. 63, Mukai Wakayama-shi**
**Wakayama 640(JP)**

(74) Representative: **Vossius & Partner**
**Siebertstrasse 4 P.O. Box 86 07 67**
**W-8000 München 86(DE)**

(54) **Yarn for use in setup.**

(57) A yarn (3) for use in setup comprising an elastic yarn (1) and fiber bundles (2) with which the elastic yarn (1) is covered or an elastic yarn and fiber bundles, which are twisted, each of the fiber bundles (2) consisting of highly abrasion-resistant fibers having great tensile strength. An alternative embodiment of the invention comprises a plurality of the above-mentioned yarns twisted.

*Fig. 1*

## BACKGROUND OF THE INVENTION

The present invention relates to a yarn for use in setup in a weft knitting machine. The yarn according to the present invention is especially useful when setup is required for each garment.

Two methods of weft knitting are known. One of them is a continuous method in which one garment is connected to another by means of a raveling cord or the like. In the other of the known methods, a single garment constitutes a batch of knitting.

A significant feature of the continuous method is predicated on the point that it is only at the time of beginning to knit a first garment that stitches are formed by means of a yarn for use in setup.

The advantage offered by this method consists in the point that, even if the first garment is defectively knitted, the second and the succeeding garments can be of excellent fabrics.

The other of the known methods, in which each garment constitutes a unit of weft knitting, is suited for a flexible manufacturing system to cope with diversified demands for knitted goods, and is in the limelight from the standpoint of resource-saving and labor-saving efforts and in view of the fact that knitters are studying the ways of adding more value to their goods and using high-grade materials such as wool.

At each time of beginning to knit a garment by the latter method, stitches are formed by means of a yarn for use in setup. Suitable tension is exerted on them while knitting proceeds. This method can avoid the losses which have so far been arising out of the cutting process and have amounted to 20 to 30 per cent even under normal conditions. Thus, this method provides an efficient means for making full use of the fabrics.

Unlike the continuous method, the latter method does not include a waste course and obviates the necessity of providing a process for disposing of waste products.

Furthermore, the latter method allows a knitting process and a sewing process to be directly connected to each other in a production line, because a single garment constitutes a batch of knitting. Thus, this method serves for the improvement of productive efficiency and the reduction of time required for knitting.

In either of the above-described known methods, machine sewing thread made of polyester or nylon fibers, or acrylic waste yarn is commonly used for setup.

From the standpoints of abrasion resistance, tensile strength and elasticity, however, the above-mentioned machine sewing threads and waste yarns are far from satisfactory for use in setup. Machine sewing threads are in want of elasticity, although they have mechanical strength. Waste yarns are in want of mechanical strength, although they have elasticity to some extent.

Knitting needles slightly vibrate and machine sewing threads or waste yarns used for setup undergo tension while knitting proceeds. Therefore, when machine sewing thread having little elasticity or waste yarns having insufficient mechanical strength are used for setup, this tension makes the waste yarns susceptible to breakage, while the machine sewing threads, which are in want of elasticity, are prone to slip out of the knitting needles.

Consequently, knitted goods are prone to have irregular Stitches.

These problems are especially serious in the second one of the above-described known methods, because that method is accompanied by high frequency in use of the yarn for setup.

## SUMMARY OF THE INVENTION

It is an object of the present invention to provide a yarn for use in setup, which allows knitted goods to be manufactured by a weft knitting machine in such a manner that the yarn does not break or slip out of the knitting needles but forms regular stitches.

According to the present invention, a yarn for use in setup comprises an elastic yarn and fiber bundles with which the elastic yarn is covered or an elastic yarn and fiber bundles, which are twisted, each of the fiber bundles consisting of highly abrasion-resistant fibers having great tensile strength.

Other and further details of the present invention are hereinafter described with reference to the accompanying drawings.

## BRIEF DESCRIPTION OF THE DRAWINGS

Fig. 1 is a perspective view of a yarn for use in setup in according to the present invention;
Fig. 2 is a longitudinal section thereof;
Fig. 3 is a transverse cross section thereof;
Fig. 4 is a front view of yarns twisted thereof; and
Fig. 5 is a front view, illustrating the unraveled condition thereof.

## DESCRIPTION OF THE PREFERRED EMBODIMENTS

In a first embodment of the invention, the yarn for use in setup comprises an elastic yarn and fiber bundles with which the elastic yarn is covered or an elastic yarn and fiber bundles, which are twisted, each of the fiber bundles consisting of highly abrasion-resistant fibers having great tensile strength.

This yarn for use in setup is allowed to have elasticity because of the elastic yarn covered with the fiber bundles, and is allowed to have mechanical strength because of the fiber bundles. This elasticity and mechanical strength are great enough to resist tension and frictional force to which the yarn is subjected while knitting proceeds. Thus the yarn hardly breaks or slips out of the knitting needles or forms irregular stitches.

In a second embodiment of the invention, the yarn for use in setup comprises a plurality of the above-mentioned yarns twisted, and each of the yarns consists of an elastic yarn and fiber bundles with which the elastic yarn is covered or an elastic yarn and fiber bundles, which are twisted, the fiber bundles in turn consisting of highly abrasion-resistant fibers having great tensile strength.

In this embodiment, mechanical strength is so enhanced by a plurality of the yarns twisted that the yarn hardly breaks.

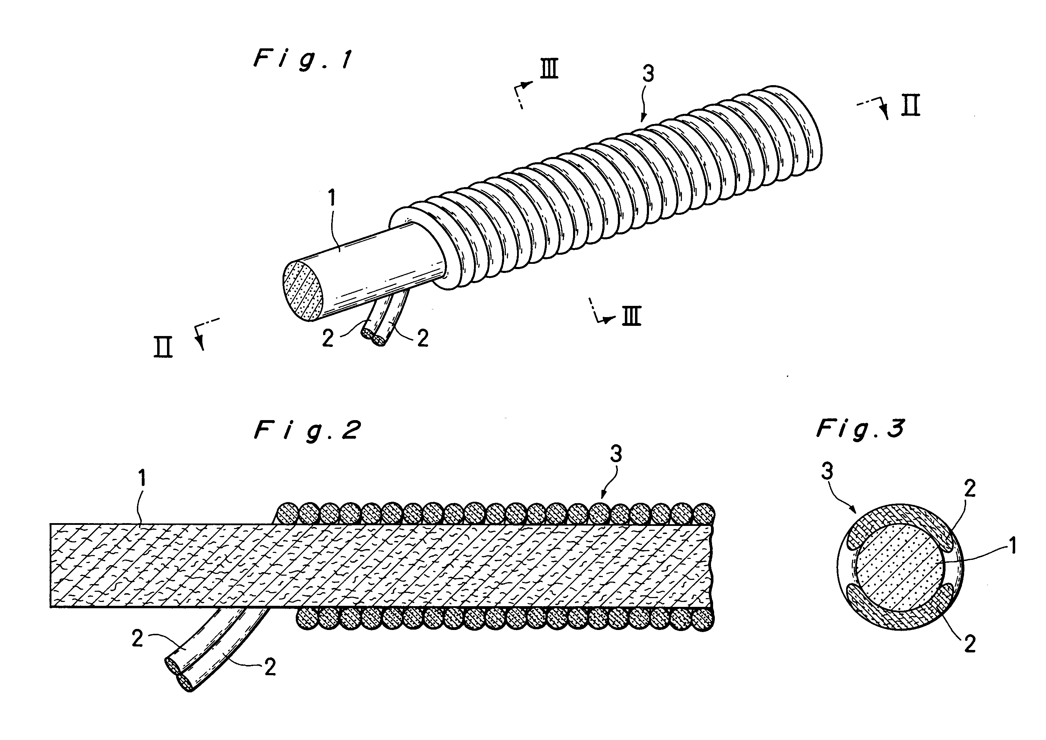

Fig. 1 shows an example of the yarn for use in setup in accordance with the present invention. Fig. 2 is a longitudinal section thereof, while Fig. 3 is a transverse cross-section thereof.

Referring now to Fig. 1, the yarn for use in setup is denoted generally by the numeral 3. The yarn 3 comprises an elastic yarn 1 and two fiber bundles 2. The elastic yarn 1, which is of round cross-section, and the fiber bundles 2 with which the elastic yarn 1 is covered. Alternatively, the fiber bundles 2 are twisted with the elastic yarn 1.

The elastic yarn 1 is made of a highly elastic material such as polyurethane or rubber, while the fiber bundles 2 consist of highly abrasion-resistant fibers having great tensile strength. Preferably, they are made of polyester, nylon, vinylon, acrylic fibers or the like.

An S twist is given to one of the two fiber bundles 2, while a Z twist is given to the other. The result is that, even if they relax, they remain conforming closely to the surface of the elastic yarn 1 and, even if they are twisted excessively, the fibers do not break.

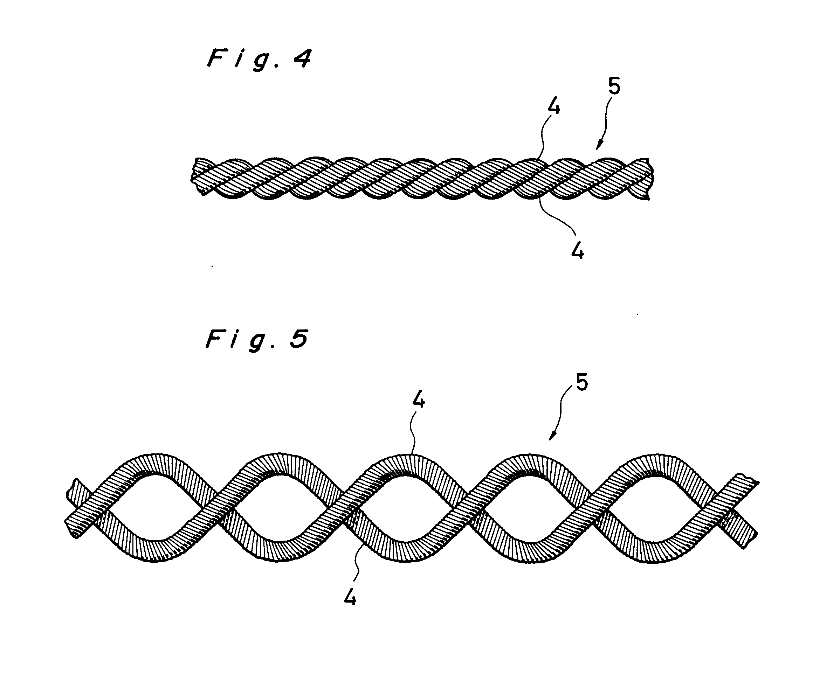

Fig. 4 shows another example of the yarn for use in setup according to the present invention, and Fig. 5 shows an unraveled condition thereof.

Referring now to Fig. 4, the yarn for use in setup is denoted generally by the numeral 5. The yarn 5 comprises two yarns 4 twisted, and each of the yarns 4 is the same as the yarn 3 shown in Fig. 1. In other words, each of the yarns 4 comprises an elastic yarn 1 and two fiber bundles 2.

It is preferable to twist two yarns 4 while untwisting each of them. Such yarns 4 will enhance the elasticity of the yarn 5 and ensure more reliably that yarn breakage will not occur.

While this invention has been described particularly in connection with the case where two fiber bundles are used, it is to be understood that this was merely given as a preferred embodiment of the invention and is not to be deemed to restrict the same. A suitable number of fiber bundles may be used in due consideration of the mechanical strength of the material used. This holds good for the number of the yarns as well.

## Claims

1. A yarn (3) for use in setup , characterized in that said yarn (3) comprises:
an elastic yarn (1); and
fiber bundles (2) with which said elastic yarn is covered,
each of said fiber bundles (2) consisting of highly abrasion-resistant fibers having great tensile strength.

2. A yarn (5) for use in setup, characterized in that said yarn (5) comprises:
an elastic yarn (1); and
fiber bundles (2), which are twisted with said elastic yarn (1),
each of said fiber bundles (2) consisting of highly abrasion resistant fibers having great tensile strength.

3. A yarn (5) for use in setup, characterized in that said yarn (5) comprises a plurality of yarns twisted, each of said yarns (5) consisting of an elastic yarn (1) and fiber bundles (2) with which said elastic yarn (1) is covered, said fiber bundles (2) in turn consisting of highly abrasion-resistant fibers having great tensile strength.

4. A yarn (5) for use in setup, characterized in that said yarn (5) comprises a plurality of yarns twisted, each of said yarns consisting of an elastic yarn (1) and fiber bundles (2), which are twisted, said fiber bundles (2) in turn consisting of highly abrasion-resistant fibers having great tensile strength.

5. The yarn for use in setup as set forth in any one of claims 1 to 4, wherein said elastic yarn (1) is made of polyurethane or rubber.

6. The yarn for use in setup as set forth in any one of claims 1 to 5, wherein said fiber bundles (2) are made up of polyester fibers.

Fig.1

III

3

1

II

2    2

II

III

EP 0 468 067 A1

Fig.2

1

3

2

2

Fig.3

3

2

1

2

Fig. 4

Fig. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | FR-A-1 421 686 (THE HALE MANUFACTURING CO.) <br> * Page 1, column 2, lines 15-28; claim 2(a),2(b) * <br> --- | 1,2,5,6 | D 02 G 3/32 |
| A | US-A-2 057 577 (F.J. KENNEDY, NEEDHAM) <br> * Page 1, column 1, lines 3-8,32-34; figures 1,2 * <br> --- | 1-5 | |
| A | US-A-3 828 544 (HEINRICH ALKER) <br> * Column 1, lines 57-62; column 2, lines 11-14,35-41; figures 1,2,3 * <br> --- | 2 | |
| A | FR-A-1 550 048 (STRETCH YARNS INC.) <br> * Page 2, column 2, lines 7-15; figures 1,2,3,4 * <br> --- | 1,2,4 | |
| A | GB-A-1 349 783 (TORAY INDUSTRIES INC.) <br> * Page 1, lines 47-49; page 9, lines 1-4; figures 1(A),1(B) * <br> --- | 1,2,4 | |
| A | BE-A- 680 601 (IMPERIAL CHEMICAL INDUSTRIES LTD) <br> ----- | | **TECHNICAL FIELDS SEARCHED (Int. Cl.5)** <br><br> D 02 G |

The present search report has been drawn up for all claims

| Place of search | Date of completion of the search | Examiner |
|---|---|---|
| THE HAGUE | 15-02-1991 | FAIRBANKS S.A. |